(19) Europäisches Patentamt
European Patent Office
Office européen des brevets

(11) Veröffentlichungsnummer: **0 096 096 B1**

# (12) EUROPÄISCHE PATENTSCHRIFT

(45) Veröffentlichungstag der Patentschrift: **16.09.87**

(51) Int. Cl.⁴: **H 01 L 21/308**, G 03 F 7/26

(21) Anmeldenummer: **82105173.7**

(22) Anmeldetag: **14.06.82**

## ERRATUM

| DIE TEXTSTELLE: TEXT PUBLISHED: LE PASSAGE SUIVANT: | (SEITE, SPALTE, ZEILE) (PAGE, COLUMN, LINE) (PAGE, COLONNE, LIGNE) | | | LAUTET BERICHTIGT: SHOULD READ: DEVRAIT ETRE LU: |
|---|---|---|---|---|
| ..und anschliessend geätzt wird.. | 4 | 6 | 57 | .. und anschliessend das freigelegte Polysilicium geätzt wird .. |

Tag der Entscheidung über die Berichtigung ) Date of decision on rectification: ) 21.10.87

Ausgabe- und Veröffentlichungstag: ) Issue and publication date: ) Date d'edition et de ) 16.12.87

Patbl.Nr ) EPB no: ) 87/51

(19) Europäisches Patentamt
European Patent Office
Office européen des brevets

(11) Veröffentlichungsnummer: **0 096 096**
**B1**

(12) # EUROPÄISCHE PATENTSCHRIFT

(45) Veröffentlichungstag der Patentschrift: **16.09.87**

(51) Int. Cl.⁴: **H 01 L 21/308**, G 03 F 7/26

(21) Anmeldenummer: **82105173.7**

(22) Anmeldetag: **14.06.82**

(54) **Verfahren zur Einstellung des Kantenwinkels in Polysilicium.**

(43) Veröffentlichungstag der Anmeldung: **21.12.83 Patentblatt 83/51**

(45) Bekanntmachung des Hinweises auf die Patenterteilung: **16.09.87 Patentblatt 87/38**

(84) Benannte Vertragsstaaten: **DE FR GB**

(56) Entgegenhaltungen:
**EP - A - 0 001 550**
**DE - C - 2 363 466**
**DE - C - 2 617 914**

**Die Akte enthält technische Angaben, die nach dem Eingang der Anmeldung eingereicht wurden und die nicht in dieser Patentschrift enthalten sind.**

(73) Patentinhaber: **IBM DEUTSCHLAND GMBH, Pascalstrasse 100, D-7000 Stuttgart 80 (DE)**
(84) Benannte Vertragsstaaten: **DE**

(73) Patentinhaber: **International Business Machines Corporation, Old Orchard Road, Armonk, N.Y. 10504 (US)**
(84) Benannte Vertragsstaaten: **FR GB**

(72) Erfinder: **Augstein, Wolfgang, Wengertsteige 72, D-7031 Holzgerlingen (DE)**
Erfinder: **Frasch, Peter, Wilhelm-Haspel-Strasse 40, D-7032 Sindelfingen (DE)**
Erfinder: **Ivancic, Blanka, Hölderlinstrasse 7, D-7032 Sindelfingen 6 (DE)**
Erfinder: **Zügel, Markus, Dr. Dipl.-Chem., Kressbacher Strasse 2, D-7401 Kressbach bei Tübingen (DE)**

(74) Vertreter: **Kreidler, Eva-Maria, Dr. rer. nat., Schönaicher Strasse 220, D-7030 Böblingen (DE)**

**EP 0 096 096 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren zur Einstellung des Kantenwinkels von Öffnungen in einer Polysiliciumschicht, bei dem in einem photolithographischen Verfahren auf der zu ätzenden Polysiliciumschicht eine Resistmaske erzeugt und anschliessend das freigelegte Polysilicium geätzt wird.

Das erfindungsgemässe Verfahren findet Anwendung bei der Herstellung integrierter Speicheranordnungen mit mehreren in einem Halbleitersubstrat angeordneten Speicherzellen, die je einen Feldeffekttransistor (FET) und einen dazu in Reihe geschalteten Kondensator aufweisen. Die physikalischen Strukturen dieser Feldeffekttransistor-Speicheranordnung und ein geeigneter Prozess zur Herstellung dieser Strukturen sind beschrieben in der Deutschen Patentschrift 2 363 466. Charakteristisch für diesen Prozess, auf den in der speziellen Beschreibung noch näher eingegangen wird, ist die mehrlagige Gateisolation (Oxid-Nitrid), eine Abschirmungsschicht aus p-dotiertem polykristallinem Silicium und eine Diffusionsquelle aus dotiertem Oxid.

Die Anwendung des erfindungsgemässen Verfahrens ist jedoch nicht auf die Herstellung der zuvor genannten Strukturen beschränkt, sondern kann auch in zukünftigen Halbleitertechnologien Anwendung finden.

Es wurde festgestellt, dass aus Gründen der Zuverlässigkeit der Speicherzellen bei deren Herstellungsverfahren gemäss DBP 2 363 466 die Kantenwinkel von Öffnungen in der Abschirmungsschicht aus Polysilicium auf Werte unter 45° eingestellt werden müssen. Mit konventionellen photolithographischen Verfahren können diese flachen Kantenwinkel in p-dotierten Polysiliciumschichten nicht hergestellt werden, typischerweise werden steilere Winkel in der Grössenordnung von 60° bis 70° erhalten.

Es wurde bereits vorgeschlagen, dem positiven Photoresist, der in einem photolithographischen Prozess zur Herstellung von Öffnungen in Polysilicium verwendet wird, 1-Hydroxy-äthyl-2-alkylimidazolin, das unter der Bezeichnung Monazoline von Mona Industries im Handel erhältlich ist, zuzusetzen. Durch diesen Zusatz sollte der Grad der Haftung des Photoresists um die zu ätzenden Motive in der Weise beeinflusst werden, dass bei der anschliessenden Ätzung flache Kantenwinkel im Polysilicium erhalten werden. Es hat sich jedoch gezeigt, dass der Grad der Haftung des Photoresists nach diesem Verfahren schlecht kontrollierbar war.

Aufgabe der Erfindung ist daher, ein Verfahren zur Einstellung des Kantenwinkels von Öffnungen in einer Polysiliciumschicht anzugeben, bei dem die Photoresisthaftung in dem durchgeführten photolithographischen Prozess durch eine geeignete Vorbehandlung in der Weise beeinflusst wird, dass bei der nachfolgenden Ätzung der freigelegten Bereiche der Polysiliciumschicht flache Kantenwinkel erhalten werden.

Die Aufgabe der Erfindung wird gemäss Patentanspruch 1 dadurch gelöst, dass die Polysiliciumschicht 9 vor dem Auftragen der Photoresistschicht mit einer Mischung aus 5 Volumteilen Wasser und 1 bis 3 Volumteilen Ammoniak (28 bis 29 gew.-%ig) und 0,25 bis 1 Volumteil Wasserstoffperoxid (30 gew.-%ig) behandelt und dass die Behandlung bei einer Temperatur zwischen 40° und 70 °C durchgeführt wird.

Mit dem erfindungsgemässen Verfahren kann der sog. Seitenwegeffekt, der die Ausbildung eines parasitären Stromwegs zwischen Source und Drain eines FETs bei der positiven Beaufschlagung des Gates betrifft und durch bewegliche geladene Verunreinigungen in der Nähe der Kante des Metallgates verursacht wird, wirksam unterbunden werden.

In der nachfolgenden speziellen Beschreibung wird anhand der Figuren 1a bis 1c ein Verfahren zur Herstellung einer integrierten Speicheranordnung gemäss DBP 2 363 466, in das das erfindungsgemässe Verfahren eingebaut wird, näher erläutert.

Anhand von Fig. 2 wird der sog. Seitenwegeffekt, der eines der Zuverlässigkeitsprobleme dieses Verfahrens darstellt, näher erläutert. Dann folgt ein Ausführungsbeispiel der Erfindung.

Fig. 3 zeigt eine Rasterelektronenmikroskopaufnahme der Ätzkante einer Öffnung in der Polysiliciumschicht.

Zunächst wird unter Bezugnahme auf die Figuren 1a bis 1c das Verfahren zur Herstellung integrierter Speicheranordnungen nach der SAMOS-(Silicon and Aluminium Metal Oxide Semiconductor)-Technologie beschrieben.

In Fig. 1a ist ein Substrat (1) aus p-dotiertem Silicium gezeigt, auf dessen Rückseite sich eine amorphe Siliciumschicht (2) befindet, die zur Kontrolle von Leckströmen dient und durch Implantation von Argon mit einer zur Amorphisierung ausreichenden Dosis und Energie hergestellt wurde.

Die folgenden drei Prozessschritte können als SAMOS-Diffusions-Technologie zusammengefasst werden. Zunächst werden auf dem Wafer (1) in einem Reaktor mit Arsen dotiertes Siliciumdioxid (3) und auf diesem nicht-dotiertes Oxid aus der Dampfphase abgeschieden. Die ganzflächig abgeschiedene dotierte Oxidschicht wird in einem photolithographischen Prozess unter Verwendung einer ersten Maske strukturiert. Im nachfolgenden Eintreibschritt diffundiert $As_2O_3$ aus den Oxidzonen (3) zum Siliciumsubstrat (1) und wird dort reduziert:

$$2\ S_2O_3 + 3\ Si \rightarrow 4\ As + 3\ SiO_2.$$

Diese Reaktion wird in oxidierender Atmosphäre durchgeführt, wodurch die Ausbildung einer Arsenschicht verhindert wird. Nachdem die gewünschte Menge an Arsen in einem $O_2/N_2$-Zyklus in den gewünschten Bereichen der Bitleitung (4) (Source) und des Speicherknotens (5) (Drain) in das Silicium eingeführt ist, folgt ein Eintreibschritt in reinem Stickstoff, durch den das Arsen in die gewünschte Tiefe eingetrieben wird. Während der

Arsenindiffusion in $O_2/N_2$-Atmosphäre, wächst eine dünne thermische Oxidschicht auf der Waferoberfläche auf, die als Abschirmung für die nun folgende Borimplantation (6) dient.

Die Implantation von Bor, die zu einem Dotierungsprofil von etwa $1,8 \times 10^{16}$ $At/cm^3$ an der Waferoberfläche führt, dient zur Einstellung einer konstanten Schwellspannung.

Im Anschluss an die Ionenimplantation wird in einem photolithographischen Prozess unter Verwendung einer zweiten Maske das dotierte Oxid (3) über dem Speicherknoten (5) entfernt, während es über der Bitleitung (4) erhalten bleibt. Nach der Entfernung des Photoresists wird auch das dünne Eintreiboxid von der Waferoberfläche entfernt. In diesem Zustand ist die Speicherzelle in Fig. 1a gezeigt.

In der nun folgenden Serie von Prozessschritten werden Isolatoren und Leiter, die zur Kontrolle des Oberflächenzustands des Wafers dienen, hergestellt. Hierzu wird thermisch eine Oxidschicht (7) auf dem Wafer (1) aufgewachsen. Diese wird als Gateisolation des Feldeffekttransistors verwendet. Dann wird eine Silicium-Nitrid-Schicht (8) aus der Dampfphase abgeschieden. Das Dickenverhältnis beider Schichten wird auf die gewünschten Eigenschaften der herzustellenden integrierten Schaltungen abgestimmt. Über der Oxid/Nitrid-Isolation wird eine polykristalline Siliciumschicht (9) niedergeschlagen, die mit einem Akzeptormaterial, beispielsweise mit Bor auf hohe Leitfähigkeit dotiert wird. An dieser Stelle wird, wie weiter unten noch näher beschrieben wird, das erfindungsgemässe Verfahren in den Verfahrensablauf eingebaut. Das Polysilicium (9) wird anschliessend in den Bereichen, die als Gate (10) und als Kontaktstellen zum Silicium (nicht abgebildet) vorgesehen sind, in einem photolithographischen Prozess unter Verwendung einer dritten Maske entfernt. Dieser Zustand ist in Fig. 1b gezeigt.

Um die integrierte Schaltung fertigzustellen, wird durch thermische Oxidation eine zweite Oxidschicht (11) auf der polykristallinen Siliciumschicht (9) in der Weise gebildet, dass auch die Ränder der Schicht (9) vollständig mit Oxid bedeckt sind. Bei dieser Oxidation wird das Polysilicium (9) in einer Schichtdicke von etwa 300 nm in Oxid umgewandelt. Da Siliciumdioxid auf Siliciumnitrid nur sehr langsam wächst, bildet sich gleichzeitig nur eine sehr dünne Oxidschicht (11a) auf der in der Gateöffnung (10) freiliegenden Nitridschicht (8).

Unter Verwendung einer vierten Maske, die in einem photolithographischen Prozess hergestellt wird, wird das Oxid (11a) auf der Gateelektrode gleichzeitig mit den Kontaktöffnungen (nicht dargestellt) zum Polysilicium (9), dem Siliciumsubstrat (1) und den diffundierten Leitungen geätzt, was durch Einstellung der Temperatur und der relativen Konzentrationen von gepufferter Flusssäure und Wasser im Ätzmittel ermöglicht wird. Anschliessend wird auf die Oberfläche der Vorrichtung eine Aluminiumschicht (12) aufgedampft. Unter Verwendung einer fünften Maske wird diese strukturiert. Die Strukturierung erfolgt nach einem Metallabhebeverfahren, das in der Deutschen Patentschrift 2 617 914 beschrieben ist. Der Zustand nach Fertigstellung der ersten Metallisierung ist in Fig. 1c dargestellt. Isolierte Teile der Aluminiumschicht (12) stellen die elektrische Verbindung zwischen der Polysilicium-Abschirmungsschicht (9) und dem Halbleitersubstrat (1) her. Die Oberfläche der Struktur wird durch eine aufgesprühte Quarzschicht abgedeckt, die zum Schutz und zur Passivierung dient. Auf die Aufbringung einer weiteren Metallisierung wird im Rahmen dieser Beschreibung nicht näher eingegangen.

In dem Verfahren, das in den vorigen Abschnitten beschrieben wurde, treten einige Zuverlässigkeitsprobleme auf. Die einen betreffen die vertikale Bewegung von Ladungen innerhalb des Gatedielektrikums oder die vertikale Bewegung von Ladungen in das Gatedielektrikum hinein; ein weiteres Problem, auf das hier näher anhand von Fig. 2 eingegangen werden soll und dessen Beseitigung sich die Erfindung zur Aufgabe stellt, betrifft die Ausbildung eines parasitären Stromwegs (16) in einem FET zwischen Source und Drain bei der positiven Beaufschlagung des Gates. Dieser sog. Seitenwegeffekt wird durch bewegliche geladene Verunreinigungen (14) in der Nähe der Kante des Metallgates (12) und durch gleichzeitig vorhandene abgesenkte Bereiche, in die die Verunreinigungen gelangen können, verursacht. Eine wiederholte, positive Beaufschlagung des Gates bewirkt, dass die Ionen (14) in den Bereich zwischen dem Metallgate (12) und der Abschirmung (9) gelangen. Auf diese Weise kann der Zustand, der in Fig. 2 gezeigt ist, eintreten, bei dem Ionen (14) mit keinem der beiden Leiter (9), (12) in Kontakt sind. Aus dieser Ladungsanordnung resultiert ein paralleler, parasitärer Stromweg (16), der nicht wie der normale FET-Kanal (15) durch das Metallgate (12) kontrolliert wird. Es hat sich gezeigt, dass es schwierig ist, diese Ionen zu eliminieren.

Es wurde erkannt, dass es zur Vermeidung der Ansammlung leitender Verunreinigungen günstig ist, die Polysiliciumschicht (9) über dem Gate so zu ätzen, dass flache Polysiliciumkantenwinkel entstehen. Wenn diese Kantenwinkel hinreichend flach sind, wird bei der nachfolgenden Oxidation die Ausbildung eines spitzen Endes der Polysiliciumoxidkante (11) vermieden.

Es wurde festgestellt, dass es ungünstig ist, Winkel $> 35°$ in das Plysilicium zu ätzen. In diesem Fall bildet sich bei der Reoxidation eine senkrechte bis überhängende Polysiliciumoxidkante. Durch diese werden an der Gateoberfläche Verunreinigungen festgehalten oder eingeschlossen, die sich bei dem anschliessenden Aluminiumabhebeverfahren nicht mehr entfernen lassen und die, wie bereits zuvor beschrieben, zu Zuverlässigkeitsproblemen führen. Wird andererseits das Polysilicium so geätzt, dass Kantenwinkel $< 15°$ entstehen, dann wird bei der anschliessenden Reoxidation das gesamte Polysilicium, aus dem der Leiterzug besteht, oxidiert. Das hat einen beträchtlichen Ausbeuteverlust zur Folge.

Erfindungsgemäss soll durch eine geeignete Vorbehandlung des Polysiliciums sichergestellt werden, dass in dem nachfolgenden photolithographischen Prozess die Haftung des Resists auf der Polysiliciumschicht (9) in der Umgebung des zu ätzenden Gates (10) und der zu ätzenden Kontaktstellen in der Weise modifiziert wird, dass bei der auf die Belichtung, Entwicklung und Aushärtung des Photoresists folgenden Ätzung durch die Photoresistmaske in der Polysiliciumschicht Ätzwinkel zwischen 15° und 35° erhalten werden. Normalerweise werden wegen des Dotierungsprofils des Polysiliciums und wenn man nach herkömmlichen photolithographischen Verfahren arbeitet, steilere Ätzwinkel erhalten.

Überraschenderweise hat sich gezeigt, dass Vorbehandlungslösungen mit einem Gehalt an Ammoniak, Wasserstoffperoxid und Wasser, die in der Halbleitertechnologie zur Entfernung organischer Verunreinigungen von Waferoberflächen verwendet werden, für die Beeinflussung der Photoresisthaftung besonders geeignet sind, wenn die einzelnen Bestandteile in einem bestimmten Konzentrationsverhältnis in der Lösung enthalten sind. Eine weitere Beeinflussung der Steilheit des Kantenwinkels kann durch die Wahl eines bestimmten Temperaturbereiches erfolgen. Experimentelle Ergebnisse haben gezeigt, dass die Ätzwinkel mit zunehmendem Gehalt der Lösungen an Ammoniak steiler werden, und dass sie mit zunehmendem Gehalt an Wasserstoffperoxid in der Lösung flacher werden. Besonders geeignet sind Lösungen mit einem Gehalt an 5 Volumteilen Wasser, 1 bis 3 Volumteilen Ammoniak und 0,25 bis 1 Volumteil Wasserstoffperoxid. Zum Ansetzen der Lösungen werden konzentrierte wässrige Lösungen von Ammoniak (28 bis 29 gew.-%ig) und Wasserstoffperoxid (30 gew.-%ig) verwendet. Die Vorbehandlungslösungen können so lange verwendet werden, solange noch aktives Wasserstoffperoxid in dem zuvor beschriebenen Konzentrationsbereich zur Verfügung steht. Aus praktischen Gründen hat sich eine Standzeit von 4 Stunden bewährt.

Es ist vorteilhaft, wenn ausser den zuvor angegebenen Konzentrationen von Ammoniak und Wasserstoffperoxid während der Vorbehandlung der Substrate auch bestimmte Temperaturen eingehalten werden. Es wurde nämlich festgestellt, dass bei Badtemperaturen unter 40 °C der Kantenwinkel zu flach, nämlich $< 13°$ wird und dass er bei Badtemperaturen über 70 °C zu steil wird. Es ist deshalb vorteilhaft, die Vorbehandlung der Substrate, die mit der polykristallinen Siliciumschicht bedeckt sind, mit Lösungen mit einem Gehalt an Ammoniak und Wasserstoffperoxid im zuvor angegebenen Konzentrationsbereich und bei Badtemperaturen zwischen 40 und 70 °C vorzunehmen. Die Behandlungsdauer ist nicht kritisch.

Ausführungsbeispiel

Substrate 1, die mit einer Polysiliciumschicht (9) versehen sind, werden mit einer wässrigen ammoniakalischen Wasserstofferodixlösung behandelt. Die Behandlungslösung enthält 5 Volumteile Wasser, 1 bis 3 Volumteile Ammoniak und 0,25 bis 1 Volumteil Wasserstoffperoxid. Die Badtemperatur liegt, wie zuvor beschrieben, vorteilhafterweise zwischen 40 und 70 °C. Die Vorbehandlung wird innerhalb von zwei Stunden vorgenommen.

Anschliessend werden die so vorbehandelten Wafer mit einem Haftvermittler, beispielsweise mit Hexamethyldisilazan beschichtet. Dann wird ein Positivphotoresist, gelöst in einem Gemisch organischer Lösungsmittel, aufgetragen. Als solcher kommt beispielsweise ein unter dem Handelsnamen AZ 1350J von der Fa. Shipley erhältlicher Resist in Frage, der aus einem m-Kresol-Formaldehyd-Novolakharz und einem Diazoketonsensibilisator besteht, welcher als 4′-2′-3′-Dihydroxybenzophenonester der 1-Oxo-2-diazonaphthalin-5-sulfonsäure identifiziert wird. Die Photoresistschicht wird anschliessend 3 bis 15 Min. bei 80 bis 100 °C getrocknet und in bekannter Weise belichtet.

Die Belichtungsdauer richtet sich nach der Motivgrösse der gewünschten Strukturen und ist von der verwendeten Belichtungsvorrichtung abhängig.

Die belichtete Photoresistschicht wird in bekannter Weise in einem Entwickler auf der Basis von Natriumdihydrogenphosphat, Natriummetasilikat und Natriumhydroxid entwickelt und ca. 15 Minuten lang bei 130 °C gehärtet. Nach der Härtung der Resistmaske wird die Polysiliciumschicht (9) in einem $HNO_3$–HF–$H_2O$-Gemisch geätzt.

Die Messung des Kantenwinkels der Öffnungen in der Polysiliciumschicht erfolgt mit dem Rasterelektronenmikroskop (SEM) bei einer 90° Neigung der Probe.

Fig. 3 zeigt eine solche Aufnahme:

Vorbehandlung: $H_2O : NH_3 : H_2O_2 = 5 : 1 : 1$ (Volumteile

Kantenwinkel: 24°

Mit dem erfindungsgemässen Verfahren zur Einstellung des Kantenwinkels kann, wie bereits zuvor angegeben, der Seitenwegeffekt, der durch die Ausbildung eines parasitären Stromwegs zwischen Source und Drain des FETs bei der positiven Beaufschlagung des Gates durch bewegliche, geladene Verunreinigungen in der Nähe der Kante des Metallgates zustande kommt, wirksam unterbunden werden. Das hat eine Verbesserung der Produktausbeute des SAMOS-Prozesses zur Folge.

**Patentansprüche**

1. Verfahren zur Einstellung des Kantenwinkels von Öffnungen in einer Polysiliciumschicht (9), bei dem in einem photolithographischen Verfahren auf der zu ätzenden Polysiliciumschicht (9) eine Resistmaske erzeugt und anschliessend geätzt wird, dadurch gekennzeichnet, dass die Polysiliciumschicht (9) vor dem Auftragen der Photoresistschicht mit einer Mischung aus 5 Volumteilen Wasser und 1 bis 3 Volumteilen Ammoniak (28 bis 29 gew.-%ig) und 0,25 bis 1 Volumteil Wasserstoffperoxid (30 gew.-%ig) behandelt und dass die Behandlung bei einer Temperatur zwischen 40° und 70 °C durchgeführt wird.

2. Verfahren nach Anspruch 1, dadurch gekennzeichnet, dass mit Bor dotiertes Polysilicium behandelt wird.

3. Verfahren nach Anspruch 2, dadurch gekennzeichnet, dass das polykristalline Silicium (9) die gleiche Leitfähigkeit wie das Substratmaterial (1) aufweist.

4. Verfahren nach den Ansprüchen 1 bis 3, dadurch gekennzeichnet, dass nach der Behandlung mit der wässrigen Lösung von Ammoniak und Wasserstoffperoxid eine Schicht aus Positiv-Photoresist auf das Polysilicium (9) aufgetragen wird, diese nach bildmässiger Belichtung und Entwicklung gehärtet wird und die Ätzung der Polysiliciumschicht (9) durch die Maske hindurch mit einer wässrigen Ätzlösung aus Fluss- und Salpetersäure vorgenommen wird.

5. Verfahren nach einem oder mehreren der Ansprüche 1 bis 4, dadurch gekennzeichnet, dass durch die Behandlung mit der wässrigen Lösung von Ammoniak und Wasserstoffperoxid Ätzwinkel in einem Bereich von 15 bis 35° eingestellt werden.

6. Verfahren nach Anspruch 1, dadurch gekennzeichnet, dass im Anschluss an die Ätzung der Polysiliciumschicht (9) auf dieser durch Oxidation eine Siliciumdioxidschicht (11) gebildet wird.

7. Verfahren nach einem oder mehreren der Ansprüche 1 bis 6, dadurch gekennzeichnet, dass bei der Herstellung von Speicherzellen in den Gatebereichen von FETs in der Polysilicium-Abschirmschicht (9) Öffnungen (10) mit Kantenwinkeln im Bereich von 15 bis 35° erzeugt werden.

## Claims

1. Method of adjusting the edge angle of openings in a polysilicon layer (9), where in a photolithographic process on the polysilicon layer (9) to be etched a resist mask is produced and subsequently the bared polysilicon is etched, characterized in that prior to the application of the photoresist layer the polysilicon layer (9) is processed with a mixture of 5 volume parts water and 1 to 3 volume parts ammonia (28 to 29% by weight), and 0.25 to 1 volume part hydrogen peroxide (30% by weight), and that the processing is effected at a temperature between 40° and 70 °C.

2. Method as claimed in claim 1, characterized in that boron-doped polysilicon is processed.

3. Method as claimed in claim 2, characterized in that the polycrystalline silicon (9) has the same conductivity as the substrate material (1).

4. Method as claimed in any one of claims 1 to 3, characterized in that following the treatment with the aqueous solution of ammonia and hydrogen peroxide a layer of a positive photoresist is applied on the polysilicon (9), and after an imagewise exposure and development this layer is cured, and etching of the polysilicon layer (9) is effected through the mask with an aqueous etching solution of hydrofluoric acid and nitric acid.

5. Method as claimed in any one or several of claims 1 to 4, characterized in that by the treatment with the aqueous solution of ammonia and hydrogen peroxide etching angles are set within 15 and 35°.

6. Method as claimed in claim 1, characterized in that subsequently to the etching of the polysilicon layer (9) a silicon dioxide layer (11) is formed thereon by oxidation.

7. Method as claimed in any one or several of claims 1 to 6, characterized in that during the production of storage cells in the gate areas of FETs in the polysilicon field shield (9) openings (10) with edge angles between 15 and 35° are made.

## Revendications

1. Procédé pour régler l'angle d'inclinaison de bords d'ouvertures dans une couche de polysilicium (9), selon lequel on forme un masque de résine photosensible selon un procédé photolithographique sur la couche de polysilicium (9) devant être corrodée, et on réalise ensuite une corrosion dans le polysilicium déposé, caractérisé en ce qu'avant le dépôt de la couche de résine photosensible, on traite la couche de polysilicium (9) avec un mélange constitué par 5 parties en volume d'eau et 1 à 3 parties en volume d'ammoniac (28 à 29% en poids) et 0,25 à 1 partie en volume d'eau oxygénée (30% en poids) et qu'on exécute le traitement à une température comprise entre 40 et 70 °C.

2. Procédé selon la revendication 1, caractérisé en ce qu'on traite du polysilicium dopé par du bore.

3. Procédé selon la revendication 2, caractérisé en ce que le silicium polycristallin (9) possède la même conductivité que le matériau (1) du substrat.

4. Procédé selon les revendications 1 à 3, caractérisé en ce qu'après le traitement avec une solution aqueuse d'ammoniac et d'eau oxygénée, on dépose une couche formée d'une résine photosensible à effet positif sur le polysilicium (9), qu'on fait durcir cette couche après exposition et développement conformément à une image, et qu'on réalise la corrosion de la couche de polysilicium (9) moyennant l'interposition du masque, avec une solution corrosive aqueuse formée d'acide fluorhydrique et d'acide nitrique.

5. Procédé selon l'une ou plusieurs des revendications 1 à 4, caractérisé en ce qu'on règle l'angle de corrosion dans une gamme allant de 15 à 35° au moyen du traitement à l'aide de la solution aqueuse d'ammoniac et d'eau oxygénée.

6. Procédé selon la revendication 1, caractérisé en ce qu'à la suite de la corrosion de la couche de polysilicium (9), on forme sur cette dernière, par oxydation, une couche de bioxyde de silicium (11).

7. Procédé selon l'une ou plusieurs des revendications 1 à 6, caractérisé en ce que, lors de la fabrication de cellules de mémoire, on aménage dans la couche de protection en polysilicon (9), dans les zones de grille de transistors FET, des ouvertures (10) dont les bords ont des angles d'inclinaison situés dans la gamme de 15 à 25°.

FIG.1A

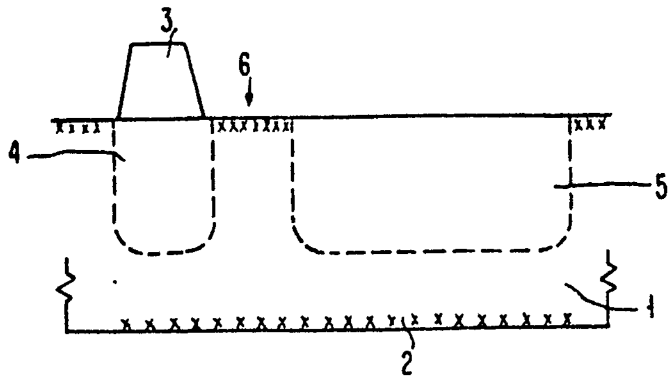


FIG.1B

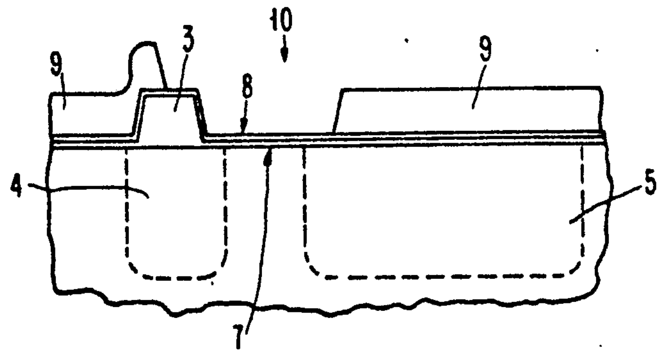


FIG.1C

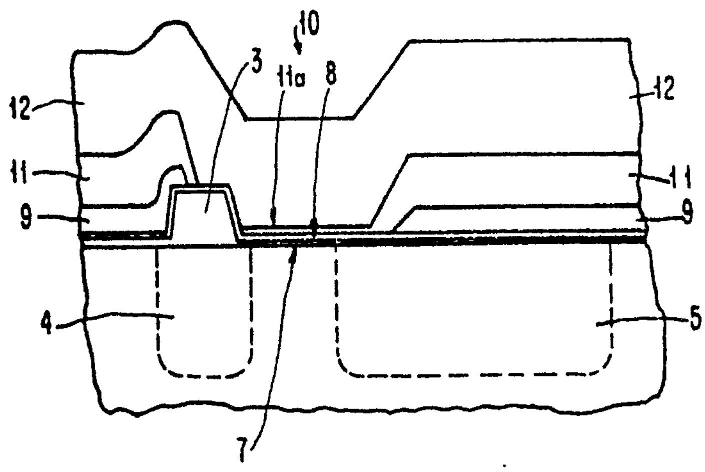


FIG. 2

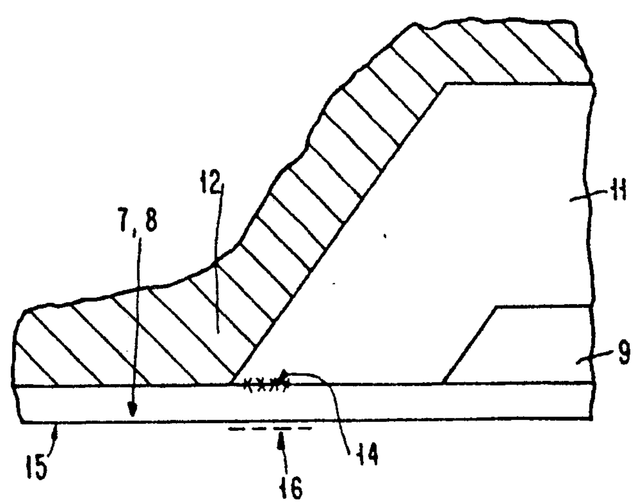

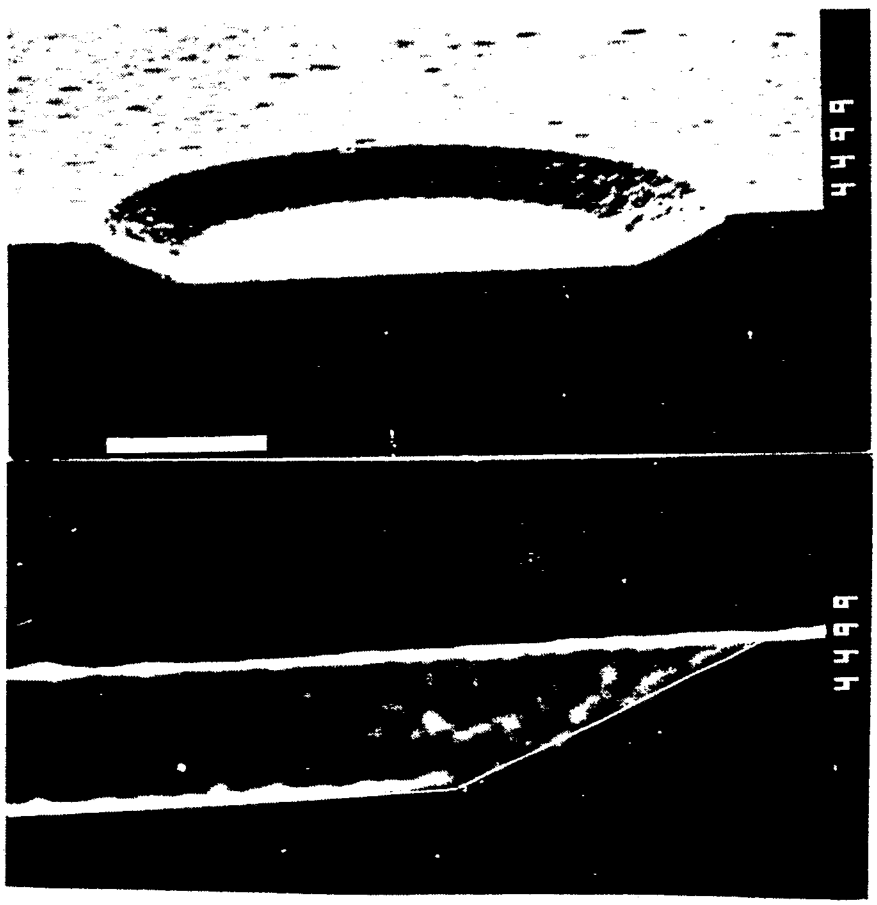

VORBEHANDLUNG:

$H_2O/NH_3/H_2O_2$ (VOLUMTEILE)

5 : 1 : 1

KANTENWINKEL: 24°

FIG. 3